**Europäisches Patentamt**

(19) **European Patent Office**

**Office européen des brevets**

(11) Veröffentlichungsnummer : **0 036 191**
**B1**

(12) **EUROPÄISCHE PATENTSCHRIFT**

(45) Veröffentlichungstag der Patentschrift :
23.05.84

(21) Anmeldenummer : 81101855.5

(22) Anmeldetag : 13.03.81

(51) Int. Cl.³ : **C 23 C 11/00**, **C 03 C 17/00//**
**C03B37/025**

(54) **Plasmabeschichtungsverfahren für die Innenbeschichtung von rohrförmigen Glasrohlingen.**

(30) Priorität : 18.03.80 DE 3010314

(43) Veröffentlichungstag der Anmeldung :
23.09.81 Patentblatt 81/38

(45) Bekanntmachung des Hinweises auf die Patenterteilung : 23.05.84 Patentblatt 84/21

(84) Benannte Vertragsstaaten :
FR GB IT NL

(56) Entgegenhaltungen :
EP-A- 0 005 963
DE-B- 1 141 850
DE-C-   904 491
JOURNAL OF THE ELECTROCHEMICAL SOCIETY,
Band 123, Nr. 7, Juli 1976, Seiten 1079-1083, D.
KUPPERS et al.: "Codeposition of glassy silica and
germania inside a tube by plasma-activated CVD"
PHYSICS & CHEMISTRY OF GLASSES, Band 21, Nr.
1, Februar 1980, Seiten 47-52, J. IRVEN et al.: "Optical
fibres produced by plasma augmented vapour deposition"

(73) Patentinhaber : Schott Glaswerke
Hattenbergstrasse 10
D-6500 Mainz (DE)

(72) Erfinder : Beerwald, Hans
Kalkgasse 2
D-5370 Kall-Sistig (DE)
Erfinder : Böhm, Günther
Haarholzerstrasse 21
D-4630 Bochum (DE)
Erfinder : Glomski, Günter
Scharnhorststrasse 2
D-4630 Bochum 1 (DE)

(74) Vertreter : Rasper, Joachim, Dr.
Bierstadter Höhe 22
D-6200 Wiesbaden (DE)

## Beschreibung

Die Erfindung betrifft ein Plasmabeschichtungsverfahren für die Innenbeschichtung von rohrförmigen Glasrohlingen für die Herstellung von Lichtleitfasern, bei welchem das Schichtmaterial aus einem entlang der zu beschichtenden Fläche strömenden Gas gebildet wird, welches durch eine elektrische Gasentladung in einer Gasentladungszone dissoziiert wird und zu einer reaktiven Abscheidung auf der zu beschichtenden Fläche des Rohlinges angeregt wird.

Bei den Plasmabeschichtungsverfahren wird das durchströmende Gas ionisiert und in seine Moleküle dissoziiert. Obwohl der Ionisationsgrad gering ist — er übersteigt selten 1 % — kann der Dissoziationsgrad hohe Werte zwischen 50 % und 100 % erreichen. Die dissoziierten Bestandteile bilden an der zu beschichtenden Wand neue Moleküle, die das Schichtmaterial darstellen.

Plasmabeschichtungsverfahren der genannten Art sind Stand der Technik (DE-OS 23 28 930 ; DE-PS 24 44 100 ; DE-OS 26 42 949 ; DE-OS 27 12 993 ; DE-OS 28 04 125 ; EP-A- 0 005 963 ; Journal of the electric chemical society, Band 123, Nr. 7, Juli 1976, Seiten 1079 bis 1083 ; Physics and Chemistry of Glasses, Band 21, Nr. 1, Februar 1980, Seiten 47 bis 52). Bei den nach dem Stande der Technik bekannten Plasmabeschichtungsverfahren der genannten Art ist die Gasentladungszone gegenüber der Länge der zu beschichtenden Fläche des Rohlinges kurz. Aus diesem Grunde muß die Gasentladungszone relativ zu dem Rohling verschoben werden, um eine gleichmäßige Beschichtung über die gesamte etwa 1 m lange zu beschichtende Fläche des Rohlinges zu erzielen.

Eine Vergrößerung der Gasentladungszone über die gesamte Länge der zu beschichtenden Fläche des Rohlinges ist bei den nach dem Stande der Technik bekannten Verfahren der angegebenen Art nicht möglich, weil sich dann das zuströmende Gas bereits im Anfangsbereich dieser Gasentladungszone verbrauchen würde, so daß der Rohling nur im Anfangsbereich der Gasentladungszone beschichtet würde. Um eine Beschichtung über die ganze Länge der zu beschichtenden Fläche in einer derart ausgedehnten Gasentladungszone zu erreichen, ist es zwar denkbar, die Gasentladung so schwach brennen zu lassen, daß der Dissoziierungsgrad niedrig bleibt und auf diese Weise auch am Ende der ausgedehnten Gasentladungszone noch unverbrauchtes Gas ankommt. Diese Lösung hätte jedoch den Nachteil, daß am Ende der Gasentladungszone unverbrauchtes Gas ausströmen würde und die Reaktionsausbeute und die Beschichtungsgeschwindigkeit gering wären.

Die notwendige Relativverschiebung zwischen Gasentladungszone und Rohling bei den nach dem Stande der Technik bekannten Verfahren erfordert eine aufwendige und störanfällige Mechanik.

Es ist deshalb Aufgabe der Erfindung, das Plasmabeschichtungsverfahren der eingangs genannten Art dahingehend weiterzubilden, daß es ohne mechanisch bewegte Teile auskommt und mit hoher Reaktionsausbeute eine Beschichtung über die gesamte Länge der zu beschichtenden Fläche ermöglicht.

Zur Lösung dieser Aufgabe schlägt die Erfindung ausgehend von den Plasmabeschichtungsverfahren der eingangs genannten Art vor, daß sich die Gasentladungszone über die gesamte Länge der zu beschichtenden Fläche des Rohlinges erstreckt und daß Impulsentladungen verwendet werden, bei denen die Impulsfolge so an die Durchlaufzeit des Gases durch die Gasentladungszone angepaßt ist, daß der zeitliche Abstand zwischen zwei aufeinanderfolgenden Impulsen gerade der Zeit entspricht, die zur Erneuerung des Gases in der Gasentladungszone benötigt wird.

Das Verfahren gemäß der Erfindung ermöglicht es bei einem Plasmabeschichtungsverfahren der eingangs genannten Art erstmals, eine Beschichtung mit hoher Reaktionsausbeute über die gesamte Länge der zu beschichtenden Fläche zu erzielen, ohne daß die Gasentladungszone relativ zu dem Rohling verschoben werden muß.

Nach dem Stande der Technik (DE-C-904 491) ist es zwar bereits seit langem bekannt gewesen, daß man bei der Durchführung von mit Gasentladung arbeitenden technischen Prozessen den technischen Prozess dadurch steuern kann, daß die Gasentladung durch Verwendung einer Impulssteuerung diskontinuierlich gestaltet wird. Bei diesem Stand der Technik dient die Impulssteuerung der Gasentladung allerdings im wesentlichen dazu, die Werkstückoberfläche nicht zu heiß werden zu lassen, d. h. thermisch zu entlasten. Irgendwelche Hinweise, wie man mit Hilfe einer in bestimmter Art und Weise auf den Gasdurchfluß abgestimmten Impulssteuerung der Gasentladung die zu beschichtende Fläche eines Rohlinges gleichzeitig über die gesamte Länge dieser Fläche erreichen kann, enthält dieser seit langem bekannte Stand der Technik nicht.

Bei einer bevorzugten Ausführungsform des Verfahrens gemäß der Erfindung haben die Impulsentladungen ein kleines Tastverhältnis, von 0,01 bis 0,1. Ein derart kleines Tastverhältnis ist möglich, weil die Zündung der Gasentladung und die Dissoziierung und der Abscheidevorgang nur wenige Millisekunden in Anspruch nehmen. Demgegenüber ist die Zeit, die für die Erneuerung des verbrauchten Gases benötigt wird und gemäß der Erfindung dem Abstand zwischen zwei Impulsen entsprechen soll, verhältnismäßig lang, so daß sich das angegebene kleine Tastverhältnis ergibt. Die Erzeugung von langen Plasmasäulen, die sich über die gesamte Länge der zu beschichtenden Fläche des Rohlinges erstrecken, kann mit Hilfe von Mikrowellenpulsen entsprechend den Unteransprüchen 3 und 4 erfolgen oder mit elektrischen Gleich- oder Wechselfeldpulsen entsprechend Unteranspruch 5.

Bei der Mikrowellenanordnung wird das koaxiale System bestehend aus Plasmasäule, Glasrohr und Metallrohr als Wellenleiter benutzt.

Ein axiales Längsfeld kann einfach durch innere Elektroden in der Nähe der Rohre angelegt werden oder — bei genügend hohen Feldfrequenzen — durch äußere Elektroden.

Ein weiterer Vorteil des erfindungsgemäßen Verfahrens liegt darin, daß einfache Entladungsgeometrien verwendet werden können. Eine Inhomogenität der Beschichtung in Längsrichtung, die durch den axialen Druckgradienten im strömenden Gas verursacht wird, kann durch Einstellung ungleicher Impulsleistungen der beiden Magnetrons vermindert werden.

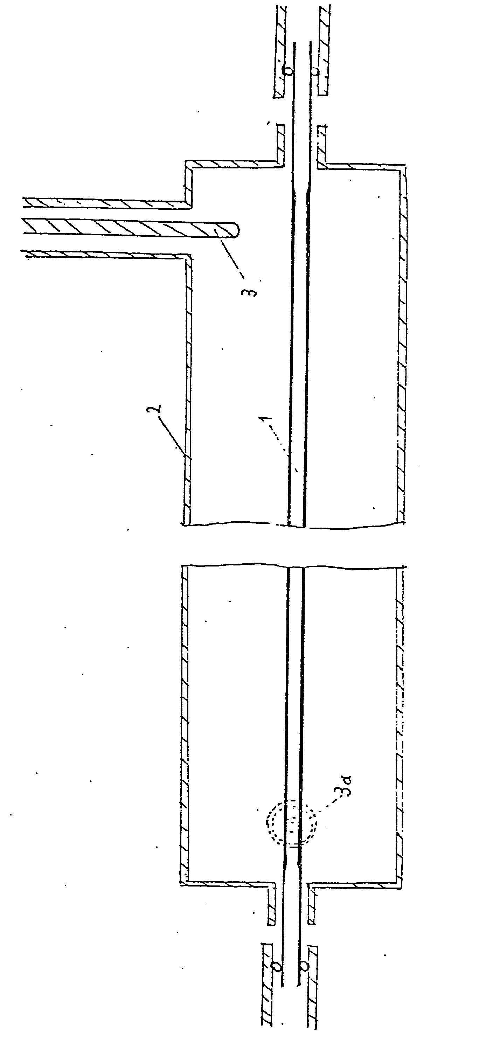

Ein Ausführungsbeispiel, bei ein aus einem Quarzglasrohr bestehender Rohling mit dotiertem $SiO_2$ nach dem erfindungsgemäßen Verfahren mit 500 W mittlerer Mikrowellenleistung beschichtet wird, wird im folgenden anhand der Zeichnung näher erläutert :

Der mit dem Bezugszeichen 1 bezeichnete, aus einem Quarzrohr (Innendurchmesser 1 cm, Länge 1 m) bestehende Rohling befindet sich koaxial in einem heizbaren Edelstahlrohr 2, dessen Durchmesser 9 cm beträgt. Die elektrische Energie zur Plasmaerzeugung wird von zwei Magnetrons (Typ YJ 1500, Frequenz 2 450 MHz) geliefert, die mit synchronen Stromimpulsen betrieben werden. Die Mikrowellenenergie wird mittels zweier Stifte 3 und 3a angekoppelt. Auf diese Weise werden zwei $H_{11}$-Wellen erregt, die senkrecht zueinander polarisiert sind, so daß eine gegenseitige Beeinflussung der beiden Magnetrons vermieden wird. Die Durchströmgeschwindigkeit des Gases ($SiCl_4$ + $O_2$ + $GeCl_4$, Gesamtdruck 13 mbar) durch den Rohling 1 beträgt 10 m/s. Daraus folgt für den Impulsabstand eine Dauer von 100 ms. Die Impulsleistung je Magnetron ist 5 kW. Bei einer Impulsdauer von 5 ms ist die mittlere Gesamtleistung 500 W. Eine mögliche Inhomogenität der Beschichtung in Längsrichtung des Rohlinges 1, die durch den axialen Druckgradienten im strömenden Gas verursacht wird, kann durch Einstellung ungleicher Impulsleistungen an den beiden in der Zeichnung nicht dargestellten Magnetrons weitgehend ausgeglichen werden. Die Innenbeschichtung des Rohlinges 1 erfolgt über die gesamte Länge der zu beschichtenden Fläche, d. h. über den Abschnitt des Rohlinges 1, der sich in dem Stahlrohr 2 befindet, wo die zur reaktiven Abscheidung benötigte Gasentladungszone erzeugt wird.

## Ansprüche

1. Plasmabeschichtungsverfahren für die Innenbeschichtung von rohrförmigen Glasrohlingen für die Herstellung von Lichtleitfasern, bei welchem das Schichtmaterial aus einem entlang der zu beschichtenden Fläche strömenden Gas gebildet wird, welches durch eine elektrische Gasentladung in einer Gasentladungszone dissoziiert wird und zu einer reaktiven Abscheidung auf der zu beschichtenden Fläche des Rohlinges angeregt wird, dadurch gekennzeichnet, daß sich die Gasentladungszone über die gesamte Länge der zu beschichtenden Fläche des Rohlinges (1) erstreckt und daß Impulsentladungen verwendet werden, bei denen die Impulsfolge so an die Durchlaufzeit des Gases durch die Gasentladungszone angepaßt ist, daß der zeitliche Abstand zwischen zwei aufeinanderfolgenden Impulsen gerade der Zeit entspricht, die zur Erneuerung des Gases in der Gasentladungszone benötigt wird.

2. Plasmabeschichtungsverfahren nach Anspruch 1, dadurch gekennzeichnet, daß die Impulsentladungen ein kleines Tastverhältnis von 0,01 bis 0,1 haben.

3. Plasmabeschichtungsverfahren nach den Ansprüchen 1 und 2, dadurch gekennzeichnet, daß die gesamte beschichtende Rohrlänge des Rohlinges (1) koaxial in einem Metall-Rohr (2) angeordnet ist und die Gasentladung mit Mikrowellen erzeugt wird.

4. Plasmabeschichtungsverfahren nach den Ansprüchen 1 bis 3 dadurch gekennzeichnet, daß die Mikrowellenentladung an mehreren Stellen entlang der Achse des zu beschichtenden Rohlinges (1) eingekoppelt wird.

5. Plasmabeschichtungsverfahren nach Anspruch 1, dadurch gekennzeichnet, daß die Gasentladung durch ein elektrisches Längsfeld erzeugt wird, daß sich über die gesamte in beschichtende Länge des Rohlinges (1) erstreckt.

## Claims

1. A plasma coating method for coating the interior of glass pipe blanks to be used for the manufacture of optical waveguides, in which method the coating material is formed from a gas flowing along the surface to be coated, the said gas being dissociated by an electrical gas discharge in a gas discharge zone, and being stimulated to reactive deposition on the surface of the pipe blank to be coated characterized in that the gas discharge zone extends over the total length of the surface of the pipe blank (1) to be coated, and that pulse discharges are employed the pulse sequence of which is adjusted to the transit time which the gas takes to flow through the said discharge zone, so that the time interval between two successive pulses corresponds to the time which is required for the replenishment of the gas in the gas discharge zone.

2. A plasma coating method according to claim 1 characterized in that the pulsing ratio of the pulse discharge is small, and is between 0.01 and 0.1.

3. A plasma coating method according to claims 1 and 2 characterized in that the total length of the pipe blank (1) to be coated is coaxially mounted in a metal pipe (2), and that the gas discharge is generated by microwaves.

4. A plasma coating method according to claims 1, 2 and 3 characterized in that the microwave power is introduced at various places along the axis of the portion of the blank to be coated.

5. A plasma coating method according to claim 1 characterized in that the gas discharge is generated by an electrical longitudinal field which extends over the total length of the pipe blank to be coated.

### Revendications

1. Procédé de revêtement par plasma pour le revêtement intérieur d'ébauches tubulaires en verre pour la fabrication de fibres conductrices de lumière, suivant lequel la matière de revêtement est formée à partir d'un gaz s'écoulant le long de la surface à revêtir, qui est dissociée par une décharge gazeuse électrique dans une zone de décharge gazeuse et qui est sollicitée en vue d'un dépôt réactif sur la surface d'ébauches à revêtir, caractérisé en ce que la zone de décharge gazeuse s'étend sur toute la longueur de la surface d'ébauche (1) à revêtir et en ce qu'on utilise des décharges pulsées dans lesquelles la séquence des impulsions est adaptée au temps de passage du gaz dans la zone de décharge gazeuse de manière que l'espacement temporel entre deux impulsions successives corresponde précisément au temps qui est nécessaire pour le renouvellement du gaz dans la zone de décharge gazeuse.

2. Procédé de revêtement par plasma selon la revendication 1, caractérisé en ce que les décharges pulsées ont un faible rapport d'impulsions compris entre 0,01 et 0,1.

3. Procédé de revêtement par plasma selon l'une des revendications 1 et 2, caractérisé en ce que la totalité de la longueur d'ébauche tubulaire (1) à revêtir est disposée coaxialement dans un tube métallique (2) et en ce que la décharge gazeuse est produite avec des microondes.

4. Procédé de revêtement par plasma selon l'une des revendications 1 à 3, caractérisé en ce que la décharge avec microondes est établie en plusieurs endroits le long de l'axe de la partie de l'ébauche (1) à revêtir.

5. Procédé de revêtement par plasma selon la revendication 1, caractérisé en ce que la décharge gazeuse est produite par un champ électrique longitudinal qui s'étend sur toute la longueur à revêtir de l'ébauche (1).

1